# EUROPEAN PATENT APPLICATION

(11) **EP 1 093 903 A1**
(43) Date of publication of application: **25.04.2001**
(21) Application number: 00309290.5
(22) Date of filing: 20.10.2000
(51) Int. Cl.: B29C 45/14, H05K 9/00

(54) **Compartmentalized moulded shielding housings**

(30) Priority: 21.10.1999 US 425161
(71) Applicant: NATIONAL-STANDARD COMPANY, Niles Michigan 49120 (US)
(72) Inventor: Burton, Paul, Grand Rapids, Michigan 49508 (US)
(74) Representative: Newby, Martin John

(57) **Abstract**

An apparatus and method for molding compartmentalized shielding structures or housings is disclosed. The molding apparatus includes a core portion (14) and a cavity portion (16) with either the core portion or the cavity portion having a recess (15) adapted to instructually arrange co operate with a plunger member (18) which is operable between an extended and a collapsed position. A conductive flexible shielding material (24) is positioned on at least the surface of the plunger (18) such that when the plunger (18) is operated to the retracted position, the exposed ends (25) of the shielding material (24) are positioned within the recess (15) of the core or cavity portion. Injection of the moldable plastic into the molding apparatus results in a molded housing having a compartmentalized shielding structure integrally molded to the plastic housing.

## Description

### Background of the Invention

The present invention relates to molded electromagnetic shielding housings that contain separate shielded compartments or housings within the externally molded shielding housing to prevent electromagnetic interference(E.M.I.) and or radio frequency interference (R.F.I.) from entering or emitting from electronic devices contained within the externally molded shielding housing.

Electromagnetic interference shielding structures have been developed to provide protection for electronic components or devices from electromagnetic energy, including radio frequency interference. Such shielding structures or housings have been designed to provide protection for the enclosed electronic device by preventing electromagnetic wave energy from penetrating into the structure as well as from escaping from the structure.

Previous attempts to provide electromagnetic shielding housings have been made by the utilization of component sheet metal boxes, conductive materials applied to a molded plastic housing, die cast parts to construct a housing and filled resins containing metal fibers which act as a sealing envelope. However, the assembly of such die cast parts or panels to provide a sheet metal electromagnetic shield has found only limited acceptance because of the difficulties of weight restrictions and the inability to make round shapes, noise problems associated ith the rattling of the vibration of the shielding components and the requirement of multiple parts to assemble a box-like housing. The use of conductive materials for providing electromagnetic shielding include electroplating metal onto a plastic, a process which requires multiple processing steps, provides poor performance, is cost prohibitive, presents environmental problems and is susceptible to chipping and flaking. Also, the utilization of die cast or metal panels to provide the shielding housing requires the use of external connections at the joints of the panels to provide a satisfactory box-like enclosure. Such assembly techniques are expensive, time consuming and oftentimes provide a structure which does not properly shield the enclosed electronic device. Finally, shielding structures comprised of filled resins containing metal fibers are very expensive and cause excessive wear in insert molding tooling and exhibit poor shielding properties.

Also, the prior art shielding structures do not provide shielding structures wherein, within each enclosed shielded housing, separate shielding compartments integral with the outer shielding housing exist. Accordingly, such prior art structures require complex secondary operations to enclose, for example, the power sources, to shield them from adjacently mounted power sources within the externally molded shielding housing. Accordingly, shielded compartments located within an external shielding structure which are integrally molded to the external shielding housing require expensive assembly and require additional processing steps. Accordingly, such structures are not available to the marketplace.

### SUMMARY OF THE INVENTION

One object of the present invention is to provide a method of injection molding of compartmentalized molded shielding housings within an external shielding housing.

It is a further object of the present invention to provide injection molded box-like shielding housings which contain integral shielding compartments therein.

It is yet another object of the present invention to provide a method and apparatus for injection molding compartmentalized shielding housings which may be readily assembled to enclose and shield electronic devices contained therein.

Still a further object of the present invention is to provide a molded box-like shielding housing or structure which includes shielded compartments integrally molded therein and which contains a conductive grid material which is non-reactive and non-corrosive with respect to the molded plastic.

The novel compartmentalized shielding housings or structures in accordance with the present invention are obtained by molding the shielding housing in an injection mold. The injection molding operation includes a separate plunger member, associated with either the core or cavity portions of the mold, and structurally arranged within the core or cavity portions structure to mount and position a separate sheet of conductive grid material about the plunger for incorporation within the molded shielding structure. Such positioning of the conductive grid material permits the incorporation of the conductive grid material to provide a separate shielded box-like housing within the externally molded box-like shielding housing. Before the mold is closed, the placement and retention of an additional sheet of grid material in the mold is facilitated by magnetic or other positioning means. When the mold is closed and plastic is injected into the mold, the resultant molded box-like shielding housing containing an integrally molded compartmentalized housing structure is obtained.

During the molding operation, the plunger member, associated with either the core or cavity portion, which mounts the sheet of grid material, is moved interiorly within a recess in either or both of the core or cavity portion to expose a portion of the separate grid material on the plunger surface to the mold cavity,

The plunger member is designed such that it has a clearance of about 0.005 to 0.010 inches between the plunger edge and the recess wall in the core or cavity portion of the mold. Importantly, the sheet of grid conductive material is positioned over the plunger surface and includes ends which extend into the opening in the core mold. When the plunger is retracted and collapsed, the plastic is injected into the mold cavity. The flow of the injectable plastic secures the grid material to position the grid material on or fixed to a surface of the molded housing. The grid material in the molded housing provides an excellent ground contact for shielding purposes. During with the molding process, the exposed grid material on the surface of the plunger is positioned where it is substantially flush with the surface of the core or cavity portion. The injectable plastic integrally secures the exposed grid material to the molded shielding housing. The gap distance between the plunger edge and the inside surface of the recess in the core or cavity portion is between 0.005 to 0.010 inches. The thickness of the grid material is about 0.010 inch. Accordingly, the gap opening between the plunger edge and the surface of the recess results in a compression of the conductive grid material to prevent plastic flow past the plunger into the recess.

The present invention provides a molded shielding housing that contains separate box-like shielding compartments, each containing the conductive grid material, integrally secured to the overall molded shielding housing. Such a structure or housing permits separate electronic components within a device to be shielded from one another. Such electronic components could be power supplies, electronic circuits, electronic components, computer processes and electronic connectors.

During the molding operation, the conductive grid material is predeterminally positioned upon a surface of the mold cavity such that upon closure of the mold, the conductive grid material is retained and positioned within the mold cavity. Upon injection of the heated injectable plastic into the mold, the conductive grid material is positioned on and integrally fixed to a surface of the molded housing which provides an excellent contact for shielding purposes. Also, the predetermined location and placement of the grid material on the surface of the mold core or cavity, facilitates plastic flow into the mold which reduces and eliminates the knit lines occurring during the molding operation. Also, the positioning of the grid conductive material within the mold facilitates the reduction of and the impact of sink marks in the resultant molded structure containing the compartmentalized molded structures.

The preferred conductive material for use in the present invention is a mesh-like grid structure material that is available from National-Standard Company under the designation BOLTING cloth. The mesh-like grid material or substrate is a nickel-coated filament material which is compatible with the molded plastic because the nickel-coated grid material does not oxidize when integrally molded on or adjacent the surface of a molded housing. The nickel interstices of the wire grid material are bonded together at the cross-over points and permit the resultant grid material to exhibit substantial flexibility, strength and high conductivity without exhibiting the property of "sleaze," as is common with wire mesh or screen. The nickel-coated grid material may be advantageously positioned within a mold cavity and advantageously positioned about the plunger surface member and/or plunger members surfaces which results in the unique compartmentalized molded shielding housing which possesses excellent electromagnetic interference (E.M.I.) and radio frequency interference (R.F.I.) shielding properties. However, it is within the scope of the present invention that an expanded metal may be used in the present invention as the primary shield material or may be used as the supplemently compartment grid material. Also, the scope of the present invention includes the use of non-woven metal fabric or other porous planar materials as the conductive material.

The present invention consists of certain novel features and structural details hereinafter fully described, illustrated in the accompanied drawings, and specifically pointed out in the appended claims, it being understood that various changes in the details may be made without departing from the spirit or sacrificing any of the advantages of the present invention.

### DESCRIPTION OF THE DRAWINGS

The foregoing description and other characteristics, objects, features and advantages of the present invention will become readily apparent upon consideration of the following detailed description, having reference to the accompanying drawings wherein:
FIG. 1 is an enlarged schematic view illustrating the placement and retention of the conductive grid material within the mold cavity and the positioning of a separate sheet of grid material on an operable plunger in accordance with the present invention;
FIGS. 2 is an enlarged schematic view illustrating the closure of the mold cavity mold and the injection of plastic material into the mold to provide the compartmentalized molded shielded housing in accordance with the present invention shown in FIG. 1;
FIG. 3 is an enlarged schematic view illustrating the placement and retention of the conductive grid material within the mold cavity and the positioning of separate sheets of grid material on a pair of operable plungers in accordance with the present invention;
FIG. 4 is an enlarged schematic view illustrating the closure of the mold cavity and the injection of plastic material into the mold to provide the compartmentalized shielding housing in accordance with the present invention shown in FIG. 3;
FIG. 5 is an enlarged schematic view illustrating the placement and retention of the conductive grid material within the mold cavity and the positicning of separate sheets of grid material on a plurality of operable plungers on both the cavity and core portions of the molding machine to provide compartmentalized shielding housings in accordance with the present invention;
FIG. 6 is an enlarged schematic view illustrating the closure of the mold cavity and the injection of plastic material into the mold to provide the compartmentalized shielding housing in accordance with the present invention shown in FIG. 5;
FIG. 7 is a cross-sectional view of a one-piece box-like molded plastic housing having a compartmentalized shielding housing comprised of a conductive grid material molded integrally thereto;
FIG. 8 is a cross-sectional view of a one-piece box-like shielding housing having a compartmentalized shielding housing comprised of a conductive grid material molded in the apparatus of FIG. 1;
FIG. 9 is cross-sectional view of a one-piece molded plastic housing having a plurality of compartmentalized shielded housings molded integrally therein in accordance with the present invention;
FIG. 10 is cross-sectional view of a one-piece plastic molded housing having two compartmentalized shielded housings adjacent one another and integral with the molded plastic housing in accordance with the present invention;
FIG. 11 is cross-sectional view of a one-piece box-like shielded housing molded in the apparatus of FIG. 3 in accordance with the present invention;
FIG. 12 is cross-sectional view of a one-piece box-like shielded housing molded in an apparatus similar to FIG. 3 wherein the integrally molded compartmentalized shielding housings are positioned adjacent one another within the molded shielding housing;
FIG. 13 is a cross-sectional view of a one-piece plastic housing having a plurality of compartmentalized shielding housings incorporated therein on multiple surfaces of the plastic housing;
FIG. 14 is cross-sectional view of a one-piece molded plastic housing having a plurality of compartmentalized shielding housings incorporated therein and adjacent one another on each side of the molded housing in accordance with the present invention;
FIG. 15 is an enlarged cross-sectional view a one-piece box-like shielded housing molded in the apparatus of FIG. 5 wherein the integrally molded compartmentalized shielded housing are molded on each side of the molded housing in accordance with the present invention;
FIG. 16 is a cross-sectional view of a one-piece box-like shielded housing molded in an apparatus similar to that shown in FIG. 5 wherein the compartmentalized shielding housings are positioned adjacent one another on each side of the molded housing;
FIG. 17 is a cross-sectional view of a one-piece plastic housing having a plurality of compartmentalized shielding housings molded predeterminally and positioned on one surface thereof with a single box-like shielded housing molded on the opposite surface of the plastic housing in accordance with the present invention; and
FIG. 18 is an enlarged cross-sectional view taken along lines 18-18 in FIG. 17 illustrating the size and location structures of the integrally molded compartmentalized shielding housings in accordance with the present invention.

### DESCRIPTION OF A PREFERRED EMBODIMENT

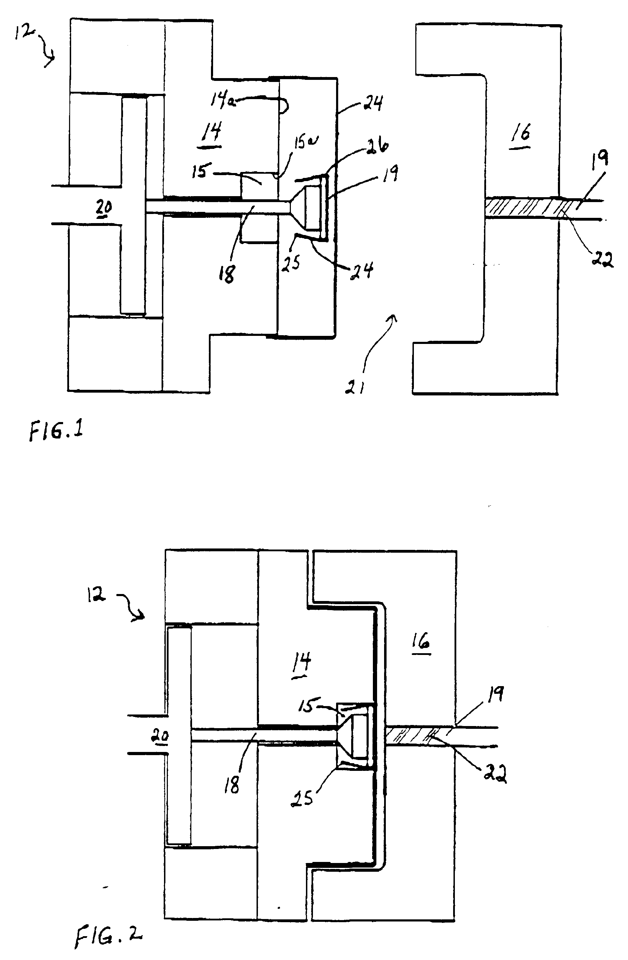

Referring now to the drawings wherein like numerals have been used throughout the several views to designate the same or similar parts, the present invention is primarily directed to molded electromagnetic shielding housings that provide enhanced shielding properties for shielding electronic interference from entering and emitting from electronic devices. As shown in FIGS. 1-6, the molded compartmentalized shielding structure or housing 10 is made by utilizing an injection molding machine 12 which is comprised of a core portion 14 and a cavity portion 16. The cavity portion 16 includes a sprue opening 19 which permits injection of the injectable plastic 22 (FIG. 1) into the injection molding machine 12. The core portion 14 includes an opening or recess 15 therein which cooperates with a lifter or plunger member 18 to provide the integrally molded compartmentalized shielding housing in accordance with the present invention, as will hereinafter be described.

The method of molding the compartmentalized electromagnetic shielding housing 10 is illustrated in reference to FIGS. 1-6 wherein a grid material or substrate 24 is predeterminally inserted into the mold cavity 21 of the molding machine 12 to engage the core portion 14 of the molding machine 12 at the surface 14a thereof when the mold is closed. The mesh-like grid material substrate or shielding material 24 useful in conjunction with the injection molding machine to provide the shielding housings in accordance with the present invention, preferably is a mesh-like nickel-coated filament material 24 which is compatible with the injectable plastic. The nickel-coated grid material has each cross-over junction bonded to one another to provide a sheet of material substantially free of deformation in the plane of the sheet. The nickel-coated filament grid material 24 is available from National-Standard Company under the designation BOLTING cloth. However, it is within the scope of the present invention that the conductive shielding material or substrate may be an expanded metal, such as stainless steel expanded metal, nickel expanded metal, aluminum expanded metal, nickel-coated expanded metal, or aluminum-coated expanded metal. Also, the conductive shielding material or substrate may be non-woven metal fabrics or other porous planar metal materials.

The nickel-coated grid material does not oxidize when integrally molded to or positioned adjacent the surface of a molded housing and provides a structure which exhibits substantial flexibility and strength, properties which facilitate the insertion and positioning of the grid material within the mold cavity of the injection molding machine 12.

The process and apparatus of the present invention requires the placement and retention of a sheet of conductive grid material or substrate 24 within the mold cavity of an injection molding machine 12. The grid or shielding material 24 is substantially flexible and is inserted onto the core portion surface 14a to conform to the configuracion of the core surface 15 as shown in FIG. 1. Securing means such as magnets or compatible adhesives (not shown) may be used to retain and position the grid material onto the core portion surface. The flexibility of the grid material permits positioning about the corners of the surface of the core portion to provide the novel molded shielding housings in accordance with the present invention.

As shown in FIG. 1, the core portion includes a recess or opening 15 structurally arranged to accommodate a lifter or plunger member 18 which is operably connected to a connector member 20. The plunger 18 includes a plunger surface 19 which is structurally arranged to receive and mount a separate sheet of grid material or substrate 24 which is inserted onto the plunger surface 19. The grid material 24 includes end portions 25 which extend inwardly towards the opening or recess 15 in the core portion 14. The plunger 18 and associated plunger surface 19 is operable between an extended position, as shown in FIG. 1, wherein the grid material 24 is positioned upon the lifter surface 19, and a closed position as shown in FIG. 2, wherein the grid material is retained between the plunger surface edge 26 and the surface 15a of the opening or recess 15 in the core portion 14. The plunger surface is substantially positioned in the same plane as the core portion surface 14a.

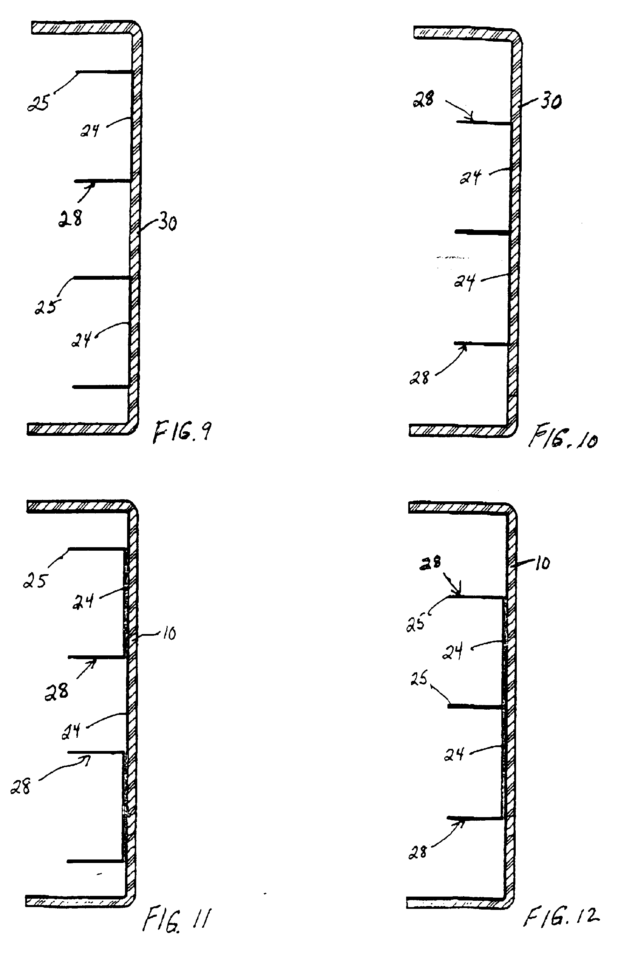

Importantly, the cross-sectional diameter of the plunger surface 19 is sized to be between about 0.005 and 0.010 inches less than the inside diameter of the opening or recess 15 in the core portion. This permits a clearance to exist between the lifter surface edge 26 and the opening or recess 15 which will accommodate the thickness of the grid or shielding material, which may run on the order of about 0.010 inches in thickness. Thus, when the plunger is actuated from the extended position, as shown in FIG. 1, to the collapsed position, as shown in FIG. 2, the gap distance or clearance between the lifter edge surface 26 and the opening or recess 15 is sufficient to compress the grid or shielding material 24 and to prevent the flow of injected plastic 22 into the opening or recess 15 in the core portion. Thus, after the molding operation has been completed, as shown in FIG. 2, the molded housing is removed when the lifter or plunger is returned to the outward extended position, as shown in FIG. 1. The molded housing obtained by the apparatus of FIG. 1 is illustrated in cross-section in FIG. 8. There, the integrally molded grid material 24 is integrally secured to the surface of the molded shielding housing 10 with a separate compartmentalized shielding portion 28 being integrally molded to the external shielding structure or housing 10. The resultant molded structure permits the predetermined separation and isolation of electronic components within an electronic device that is enclosed by the box-like shielding structure or housing 10 and permits the separation of the electronic components from power supplies, electronic circuits, computer processes and electrical connectors one from another, as desired. Moreover, it is within the scope of the present invention that the grid or shielding material 24 utilized in molding the shielding portion 28 may be the same or a different conductive material that is utilized in molding the shielding housing 10.

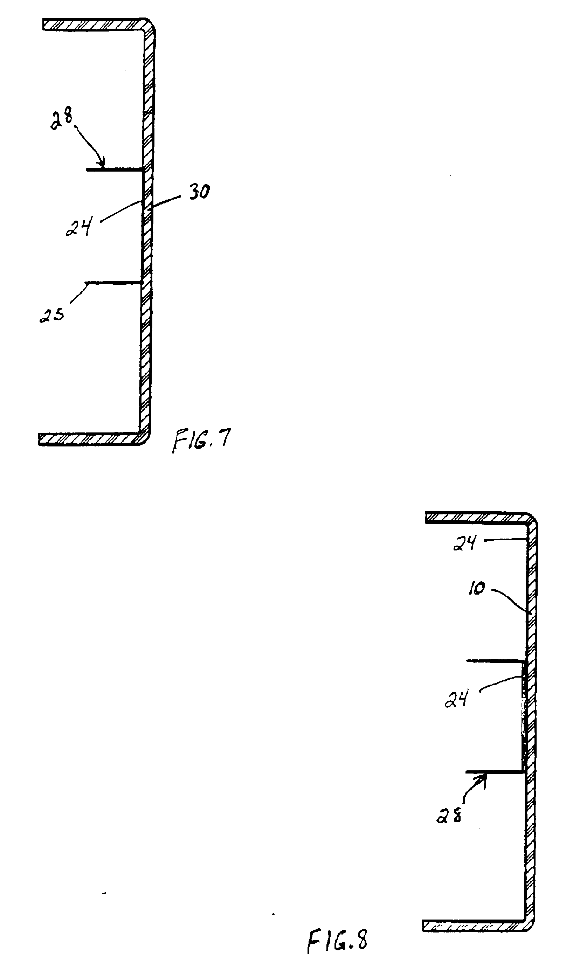

FIG. 7 illustrates a compartmentalized shielding sub-housing 28 which is integrally molded and secured to an external plastic molded housing 30 which does not include a grid material or substrate therein. Thus, the present invention includes the injection molding of plastic housings which include specialized and predetermined compartments or sub-housings 28 therein which provide a separate compartmentalized shielding sub-housing or housings within a non-shielding plastic molded housing 30.

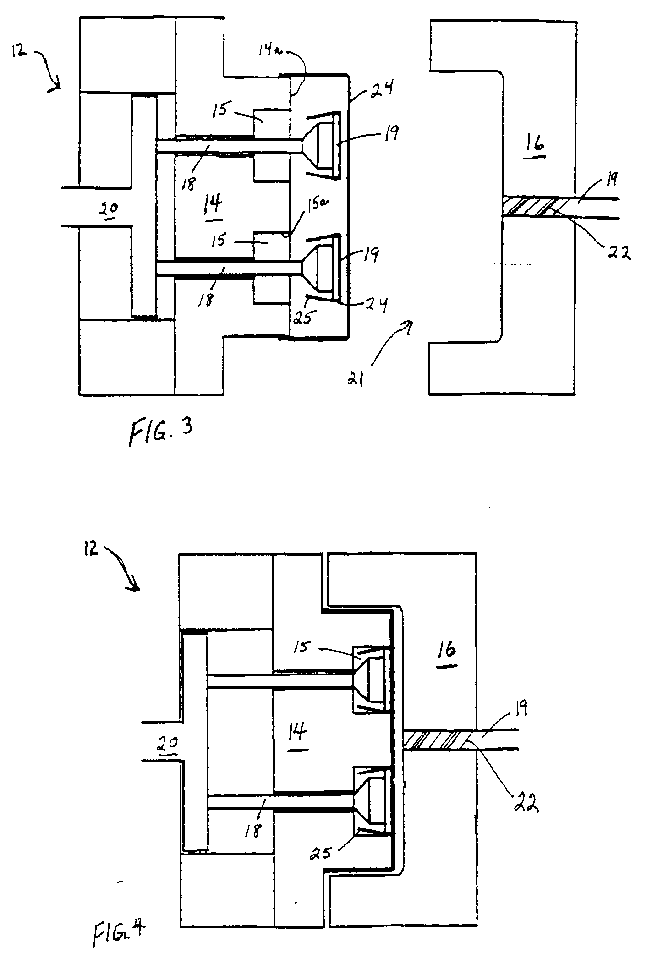

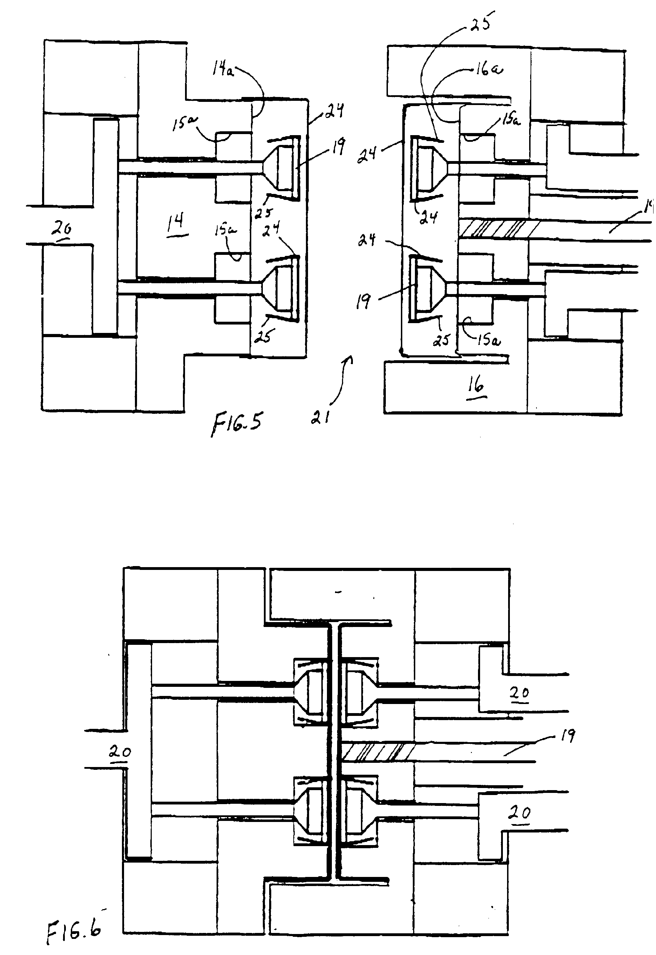

FIGS. 3 and 4 illustrate the positioning of a conductive grid material 24 within a injection molding machine 12 which includes a pair of lifter or plungers 18 which are adapted to receive and cooperate with openings or recesses 15 in the core portion 14. Again, the operation of the molding machine 12 is similar to the operation of the molding machine shown in to FIGS. 1 and 2, except the resultant molded shielding housing 10 contains a pair of compartmentalized shielding sub-housings 28, as shown in FIG. 11. Also, as shown in FIG. 12, the compartmentalized shielding sub-housings 28 may be positioned adjacent to one another or they may be separated, as shown in FIG. 11. Again, as also shown in FIGS. 9 and 10, the compartmentalized shielding sub-housing 28 may be incorporated within a non-shielding plastic molded housing 30.

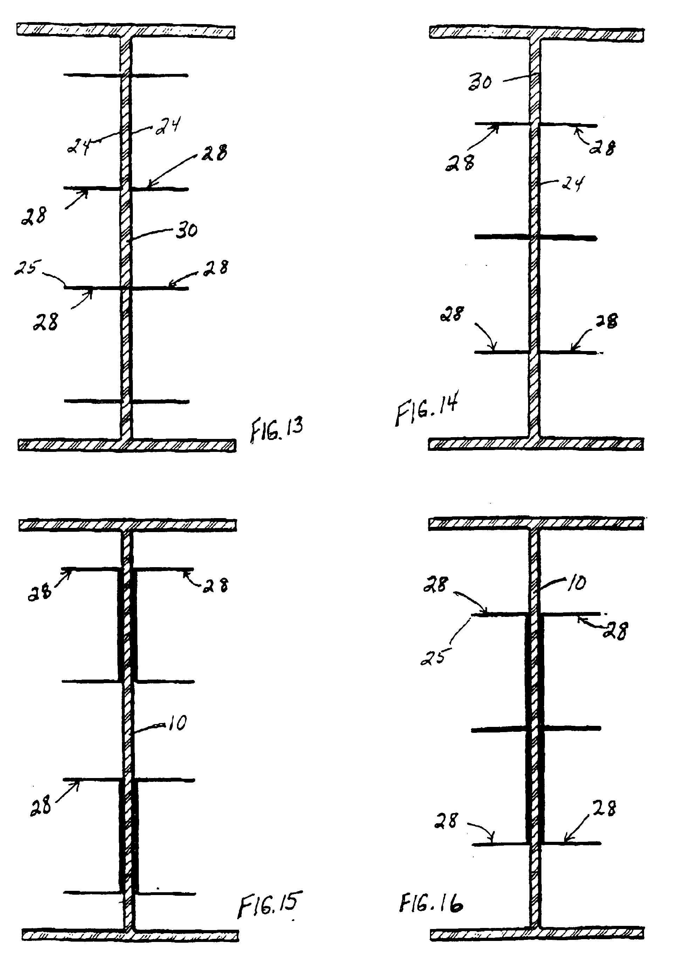

In FIGS. 5 and 6, the injection molding machine 12 again is comprised of a core portion 14 and a cavity portion 16. Both the core portion 14 and the cavity portion 16 may include one or more plunger members 18 which cooperate with associated openings or recesses 15 in the surface 14a of the core portion 14 or in the surface 16a of the cavity portion 16 to provide the novel compartmentalized shielding structures or housings 10 contemplated by the present invention. As set forth above, the plunger surface 19 of the plunger 18 is adapted to receive the conductive shielding material or substrate 24 having shielding ends 25. The substrate shielding ends 25 are structurally arranged on the plunger surface 19 to extend into the respective recesses 15 in the core and cavity portions. Upon closure of the mold, as shown in FIG. 6, a compartmentalized shielding structure or housing 10 is obtained, as shown in FIG. 15. In FIG. 15 the compartmentalized shielding structure or housing 10 includes compartmentalized shielding sub-housings 28 on one surface of the grid material 24 with a second set of compartmentalized shielding sub-housings 28 being positioned on the grid material 24 deposited on the opposite surface of the housing 10. Also the compartmentalized shielding sub-housings 28 may be spaced apart (FIG. 15) or positioned to be adjacent one another (FIG. 16), as desired.

The present invention provides also that the compartmentalized shielding sub-housings 28 may be predeterminally positioned on both sides of a injected molded housing 30 which does not include the conductive grid material incorporated therein, Specifically, FIG. 13 illustrates compartmentalized shielding sub-housings 28 positioned on opposite sides of a plastic molded housing 30 and FIG. 14 illustrates compartmentalized shielding sub-housings 24 positioned adjacent to one another on opposite surfaces of the plastic molded housing 30.

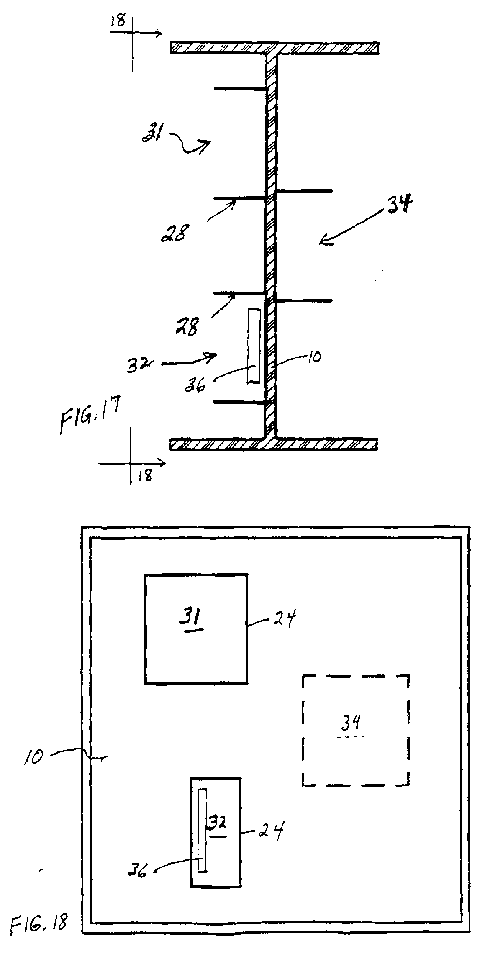

Finally, in FIGS. 17 and 18, the compartmentalized shielding sub-housings 28 may be predeterminally positioned and incorporated within the compartmentalized shielding structure housing. In FIG. 17, the compartmentalized shielding sub-housings 28 include two sub-housings 31 and 32 on the left side of the injected molded shielding housing 10 with a single compartmentalized sub-housing 34 on the opposite surface of the molded shielding housing. FIG. 18 is a cross-sectional view taken along lines 18-18 of FIG. 17 and illustrates that the position of the compartmentalized shielding sub-housings 31 and 32 within the compartmentalized shielding structure housing 10 may be of any size or shape. This permits the sizing of the compartmentalized sub-housings 28 to predeterminally enclose and shield specific-sized electronic components within the enclosed shielding housing. As shown in FIG. 17, one such power supply 36 is positioned within compartmentalized shielding sub-housing 32 with the grid end portions 25 being foldable to enclose the component from another shielded component within the overall shielding structure or housing 10.

The present invention has application in the separation of electronic components within a device that may or may not be shielded. Such devices may be power supplies, electronic circuits, component computer processors and electronic connectors.

## Claims

1. An apparatus for moulding plastics housings having compartmentalized electromagnetic shielding sub-housings therein for shielding electronic devices positioned within the plastics housing from one another, including in combination:
a core portion (14) having a moulding surface and having at least one opening (15) structurally arranged within said core portion cooperating with said moulding surface;
a cavity portion (16) having a moulding surface, with said core portion and said cavity portion being axially movable from one another to an open position and being axially movable towards one another to a closed position, with the space between said core portion (14) and said cavity portion (16) defining a mould cavity;
an injection opening (19) in at least one of said core portion (14) or said cavity portion (16) communicating with said mould cavity; and
a plunger member (18) structurally arranged for movement within said at least one opening (15) in said core portion between an extended position wherein said plunger member is positioned in said mould cavity and a retracted position wherein a planar surface of said plunger member is substantially positioned in the same plane as the moulding surface of said core portion (14), and wherein said planar surface of said plunger member (18) is adapted to receive a conductive flexible metal material (24) thereon when said plunger member is in said extended position, with said plunger member (18) being movable to said retracted position to cooperate with said at least one opening (15) in said core portion to retain said flexible metal material in said recess, such that upon the injection of a mouldable plastics through said injection opening (19) into the mould cavity, a compartmentalized shielding subhousing is integrally moulded to the moulded plastics housing.

2. An apparatus for moulding plastics housings having compartmentalized electromagnetic shielding sub-housings therein for shielding electronic devices positioned within the plastics housing from one another, including in combination:
a cavity portion having a moulding surface and having at least one opening structurally arranged within said cavity portion cooperating with said moulding surface;
a core portion having a moulding surface, with said core portion and said cavity portion being axially movable from one another to an open position and being axially movable towards one another to a closed position, with the space between said core portion and said cavity portion defining a mould cavity;
an injection opening in at least one of said core portion or said cavity portion communicating with said mould cavity; and
a plunger member structurally arranged for movement within said at least one opening in said cavity portion between an extended position wherein said plunger member is positioned in said mould cavity and a retracted position wherein the planar surface of said plunger member is substantially positioned in the same plane as the moulding surface of said cavity portion, and wherein said planar surface of said plunger member is adapted to receive a conductive flexible metal material thereon when said plunger member is in said extended position, with said plunger member being movable to said retracted position to cooperate with said at least one opening in said cavity portion to retain said flexible metal material in said recess, such that upon the injection of a mouldable plastics through said injection opening into the mould cavity, a compartmentalized shielding sub-housing is integrally moulded to the moulded plastics housing.

3. An apparatus for moulding electromagnetic shielding housings having compartmentalized electromagnetic shielding subhousings therein for shielding electronic devices positioned within the shielding housing from one another, including in combination:
a core portion having a moulding surface and having at least one opening structurally arranged within said core portion cooperating with said moulding surface;
a cavity portion having a moulding surface, with said core portion and said cavity portion being axially movable from one another to an open position and being axially movable towards one another to a closed position, with the space between said core portion and said cavity portion defining a mould cavity which is adapted to receive a conductive flexible metal material;
an injection opening in at least one of said core portion or said cavity portion communicating with said mould cavity; and
a plunger member structurally arranged for movement within said at least one opening in said core portion between an extended position wherein said plunger member is positioned in said mould cavity and a retracted position wherein the planar surface of said plunger member is substantially positioned in the same plane as the moulding surface of said core portion, and wherein said planar surface of said plunger member is adapted to receive a conductive flexible metal material thereon when said plunger member is in said extended position, with said plunger member being movable to said retracted position to cooperate with said at least one opening in said core portion to retain said flexible metal material in said recess, such that upon the injection of a mouldable plastics through said injection opening into the mould cavity, a compartmentalized shielding subhousing is integrally moulded to the moulded shielding housing.

4. An apparatus for moulding electromagnetic shielding housings having compartmentalized electromagnetic shielding subhousings therein for shielding electronic devices positioned within the shielding housing from one another, including in combination:
a cavity portion having a moulding surface and having at least one opening structurally arranged within said cavity portion cooperating with said moulding surface;
a core portion having a moulding surface, with said core portion and said cavity portion being axially movable from one another to an open position and being axially movable towards one another to a closed position, with the space between said core portion and said cavity portion defining a mould cavity which is adapted to receive a conductive flexible metal material;
an injection opening in at least one of said core portion or said cavity portion communicating with said mould cavity; and
a plunger member structurally arranged for movement within said at least one opening in said cavity portion between an extended position wherein said plunger member is positioned in said mould cavity and a retracted position wherein the planar surface of said plunger member is substantially positioned in the same plane as the moulding surface of said core portion, and wherein said planar surface of said plunger member is adapted to receive a conductive flexible metal material thereon when said plunger member is in said extended position, with said plunger member being movable to said retracted position to cooperate with said at least one opening in said core portion to retain said flexible metal material in said recess, such that upon the injection of a mouldable plastics through said injection opening into the mould cavity, a compartmentalized shielding subhousing is integrally moulded to the moulded shielding housing.

5. Apparatus according to any one of the preceding claims, wherein said conductive flexible metal material (24) is a nickel-coated grid material.

6. Apparatus according to any one of claims 1 to 4, wherein said conductive flexible metal material (24) is an expanded metal.

7. Apparatus according to claim 6, wherein said expanded metal is selected from a group comprising, stainless steel, aluminum or nickel expanded metal.

8. Apparatus according to any one of claims 1 to 4, wherein said conductive flexible metal material (24) is a non-woven metal fabric.

9. Apparatus according to any one of claim 1 to 4, wherein said conductive flexible metal is a porous planar metal.

10. Apparatus according to any one of the preceding claims, wherein said core portion (14) and said cavity portion (16) define a mould cavity having corners thereon.

11. Apparatus according to claim 10, wherein said core portion and said cavity portion further define a box-like plastics housing having said compartmentalized shielding sub-housing integrally moulded therein.

12. Apparatus according to claim 11, wherein said compartmentalized shielding sub-housing has a box-like configuration.

13. Apparatus according to any one of the preceding claims, wherein said injection opening (19) is in said cavity portion (16).

14. A method of moulding shielding housings having at least one compartmentalized shielding sub-housing in an injection moulding machine having a mould cavity defined by a core portion and a cavity portion, including the steps of:
positioning a conductive flexible metal material on a surface provided by at least one of said core and said cavity portions of the moulding machine when said core portion and said cavity portion are in an open position, with at least one of said core or said cavity portions having at least a recess therein which is structurally arranged to receive and cooperate with a plunger member operable between an extended position wherein said plunger extends into the mould cavity and a retracted position wherein the planar surface of said plunger member is substantially positioned in the same plane as the surface provided by at least one of said core and said cavity portions;
depositing a conductive flexible metal material on the planar surface of said plunger member, with said conductive metal material having end portions extending into said recess in said at least one of said core and said cavity portions;
closing the core portion and the cavity portion of the injection moulding machines to provide the mould cavity, and moving said plunger member to said retracted position such that said conductive metal material thereon is retained between said plunger member and said recess in at least one of said core or said cavity portions; and
directing injectable plastics into said mould cavity to provide a compartmentalized shielding sub-housing moulded integrally with the moulded shielding housing.

15. A method of moulding plastics housings having at least one compartmentalized shielding sub-housing therein in an injection moulding machine having a mould cavity defined by a core portion and a cavity portion, including the steps of:
positioning the core portion and the cavity portions in an open position and axially spaced apart from each other, with at least one of said core or said cavity portions having a recess therein which is structurally arranged to receive and cooperate with a plunger member operable between an extended opened position wherein said plunger extends into the mould cavity and a retracted closed position wherein the planar surface of said plunger member is substantially positioned in the same plane as the surface provided by at least one of said core or cavity portions;
depositing a conductive flexible grid material on the planar surface of said plunger member, with said grid material having grid end portions extending towards said recess in said at least one of said core and said cavity portions;
closing the core portion and the cavity portion of the injection moulding machines to define the mould cavity, and moving said plunger member to said retracted position such that said grid material thereon is retained between said plunger member and said recess in at least one of said core or said cavity portions; and
directing injectable plastics into the mould cavity to provide a compartmentalized shielding sub-housing moulded integrally with the moulded plastics housing.

16. A method of moulding electromagnetic shielding housings according to claim 14 or 15, further including the step of opening the moulding machine to remove the moulded shielding housing.

17. A method of moulding electromagnetic shielding housings according to claim 14, 15 or 16, wherein at least one of said core or said cavity portions have at least two recesses therein which are structurally arranged to receive and cooperate with at least two plunger members which are operable between an extended open position and a retracted closed position.

18. A method of moulding electromagnetic shielding housings according to any one of claims 14 to 17, wherein said conductive flexible metal material in a nickel-coated grid material.

19. A method of moulding electromagnetic shielding housings according to any one of claims 14 to 17, wherein said conductive flexible metal material is an expanded metal.

20. A method of moulding electromagnetic shielding housing according to any one of claims 14 to 17, wherein said expanded metal is selected from a group comprising, stainless steel, aluminum or nickel expanded metal.

21. In the method of moulding electromagnetic shielding housings according to any one of claims 14 to 17, wherein said conductive flexible metal material is a non-woven metal fabric.

22. A method of moulding electromagnetic shielding housings according to any one of claims 14 to 17, wherein said conductive flexible metal material is a porous planar metal.
